# EUROPÄISCHE PATENTSCHRIFT

(11) **EP 2 771 968 B1**
(45) Veröffentlichungstag und Bekanntmachung des Hinweises auf die Patenterteilung: **13.12.2017**
(21) Anmeldenummer: 11791220.4
(22) Anmeldetag: 25.10.2011
(51) Int. Cl.: H02N 2/02, H02N 2/06, F02M 51/06

(54) **STELLEINRICHTUNG**
ACTUATING DEVICE
DISPOSITIF DE COMMANDE

(43) Veröffentlichungstag der Anmeldung: 03.09.2014
(73) Patentinhaber: Robert Bosch GmbH, 70442 Stuttgart (DE)
(72) Erfinder: WUERFEL, Gernot, 71665 Vaihingen/Enz (DE); PIETSCH, Ingo, 81829 München (DE); SEBASTIAN, Thomas, 71729 Erdmannhausen (DE); JAKOBI, Andreas, 16372 Bursa (TR); KERKAMM, Ingo, 70565 Stuttgart-Rohr (DE)
(86) Internationale Anmeldenummer: PCT/EP2011/068656
(87) Internationale Veröffentlichungsnummer: WO 2013/060360

(56) Entgegenhaltungen:
- WO-A1-03/052260
- DE-A1- 19 624 006
- DE-A1- 19 918 976
- DE-A1-102010 039 165

## Beschreibung

### Stand der Technik

Die vorliegende Erfindung betrifft eine Stelleinrichtung.

Stelleinrichtungen zur Fluideinspritzung sind aus dem Stand der Technik in unterschiedlichen Ausgestaltungen mit nadelförmigen Stellelementen bekannt,

die mittels eines keramischen Piezoaktors zur Realisierung schneller Fluideinspritzungen betätigt werden. Hierbei ist es von besonderem Nachteil, dass aufgrund der Eigenschaftsdegradation der Piezoaktoren als Funktion der elektrischen Zyklenzahl keine direkte Korrelation zwischen der anliegenden Spannung und der Dehnung des Piezoaktors möglich ist. Somit kann die tatsächliche Position des Stellelements zu jedem Zeitpunkt des Einspritzvorgangs nicht exakt bestimmt werden. Ferner muss jeder einzelne Piezoaktor in der Fertigung zeit- und kostenaufwändig vermessen und codiert werden, um das individuelle Hubvermögen für eine Fluiddosierung zu ermitteln. Stelleinrichtungen umfassend zwei Piezoaktoren, die eine Ventilnadel in eine Richtung verstellen und in die entgegengesetzte Richtungen zurückstellen, sind beispielsweise aus DE 199 18 976 A1 oder DE 196 24 006 A1 bekannt. WO 03/052260 A1 offenbart eine Stelleinrichtung mit einem Piezostapel, der mindestens ein Aktorteil und ein Sensorteil umfasst.

### Offenbarung der Erfindung

Die erfindungsgemäße Stelleinrichtung mit den Merkmalen des Anspruchs 1 weist demgegenüber den Vorteil auf, dass hierbei zwei seriell angeordnete Piezoaktoren verwendet werden, die eine genaue Positionierung des Stellelements zu jedem Zeitpunkt des Einspritzvorgangs und somit eine präzisere Dosierung des eingespritzten Fluids ermöglichen. Dies wird erfindungsgemäß dadurch erreicht, dass die Stelleinrichtung ein Stellelement umfasst, welches in eine erste Richtung und eine zweite Richtung bewegbar angeordnet ist, wobei die ersten und zweiten Richtungen einander entgegengesetzt sind. Ferner umfasst die Stelleinrichtung einen ersten Piezoaktor und einen zweiten Piezoaktor, wobei der erste Piezoaktor das Stellelement in die erste Richtung stellt, und der zweite Piezoaktor das Stellelement in die zweite Richtung stellt. Die Fertigungsschritte für die Vermessung und Codierung der Piezoaktoren können somit entfallen, was zu einer beachtlichen Kostenersparnis und deutlich kürzeren Fertigungszeiten führt.

Die Unteransprüche zeigen bevorzugte Weiterbildungen der Erfindung.

Gemäß der Erfindung stellt der erste Piezoaktor das Stellelement von einer Ausgangsposition in eine Stellposition in die erste Richtung und der zweite Piezoaktor stellt das Stellelement von der Stellposition in die Ausgangsposition in die zweite Richtung zurück. Dadurch wird ein betriebssicheres Öffnen bzw. Schließen des Stellelements mit hoher Dynamik erreicht.

Weiterhin umfasst die Stelleinrichtung eine Steuereinheit, welche mit dem ersten und zweiten Piezoaktor verbunden ist. Die Steuereinheit ist ausgelegt, den ersten und zweiten Piezoaktor abwechselnd zu aktivieren bzw. anzusteuern und ferner die Signale des deaktivierten bzw. nicht angesteuerten Piezoaktors zu erfassen. Der deaktivierte Piezoaktor wird hierbei als Sensor verwendet und erfasst die vom aktivierten Piezoaktor auf ihn ausgeübte Kraft als Signal, das zur Positionsbestimmung des Stellelements verwendet werden kann. Aus dieser Information lässt sich die genaue Dehnung des ersten Piezoaktors und somit die Hubbewegung des Stellelementes bestimmen. Eine aufwändige Vermessung zur Selektion der zu verwendenden Piezoaktoren in der Fertigung kann daher entfallen.

In weiterer vorteilhafter Ausgestaltung der Erfindung umfasst die Steuereinheit eine Recheneinrichtung, welche ausgelegt ist, eine exakte Position des Stellelements basierend auf den erfassten Signalen des jeweils deaktivierten Piezoaktors zu berechnen. Aufgrund der berechneten Positionierung des Piezoaktors zu jedem Zeitpunkt des Einspritzvorgangs kann die Fluiddosierung wesentlich genauer erfolgen als über die herkömmliche Codierung des Piezoaktors. Durch den Entfall bisher notwendiger, aufwändiger Feedforward-Korrekturfunktionen in der Steuereinheit zur Richtigstellung der eingespritzten Fluidmenge kann zudem der Aufbau und die Auslegung der Steuereinheit wesentlich vereinfacht werden. Ferner kann durch einen Abgleich mit der erfassten, tatsächlich eingespritzten Fluidmenge und der von der Steuereinheit definierten Sollmenge ein Tuning, z. B. durch ein Dazwischenschalten eines weiteren Steuergeräts, welches die Sollmenge verändert, deutlich erschwert werden.

Vorzugsweise kontaktiert der erste Piezoaktor und/oder der zweite Piezoaktor das Stellelement direkt. Durch die direkte Betätigung des Stellelements können Bauteile entfallen, was die Anzahl der Bauteile minimiert und eine deutliche Kostenersparnis zur Folge hat.

In weiterer vorteilhafter Ausgestaltung der Erfindung weist der zweite Piezoaktor eine Durchgangsöffnung zum Durchführen des Stellelements auf. Dadurch wird eine verschleißarme, betriebssichere Führung des Stellelementes sichergestellt. Durch eine entsprechende Anpassung des Innenelektrodendesigns des zweiten Piezoaktors werden elektrische Überschläge an der Durchgangsöffnung auf das Stellelement vermieden.

Weiterhin bevorzugt ist das Stellelement eine Nadel, welche an einem Ende einen flachen Fußbereich aufweist, der zwischen dem ersten und zweiten Piezoaktor angeordnet ist. Dadurch können mechanische Fehler, wie z. B. ein Verklemmen des Stellelements, oder ein Verschleiß, wie z. B. durch Verkokung des Stellelements und/oder benachbarter Bauteile, aufgrund des einfachen Aufbaus der Stelleinrichtung leichter diagnostiziert werden.

Vorzugsweise umfasst die Stelleinrichtung ein Federelement zur Unterstützung einer Rückstellung wenigstens eines der Piezoaktoren. Hierdurch ist ein schnelleres Schließen des Stellelements, das mit erhöhter Rückstellgeschwindigkeit und größerer Rückstellkraft in einen Ventilsitz gepresst wird, erreichbar, wodurch zum Beispiel bei Verwendung in einem Fahrzeug eine deutlich reduzierte Fluidmenge in den Brennraum eingespritzt werden muss. Dies führt zu einem verbesserten Leerlaufverhalten und Abgasverhalten des Motors.

Weiterhin betrifft die Erfindung ein Verfahren zum Stellen einer Stelleinrichtung mit einem Stellelement, einem ersten Piezoaktor und einem zweiten Piezoaktor. Hierbei wird in einem ersten Verfahrensschritt der erste Piezoaktor in einer ersten Richtung aktiviert, um das Stellelement von einer Ausgangsposition in eine Stellposition zu stellen. Dabei arbeitet der zweite deaktivierte Piezoaktor als Sensor, der die auf ihn wirkenden Kräfte vom Stellelement aufnimmt und an die Steuereinheit übermittelt. In einem zweiten Verfahrensschritt wird der erste Piezoaktor deaktiviert und der zweite Piezoaktor in einer zweiten Richtung aktiviert, um das Stellelement von der Stellposition in die Ausgangsposition zurückzustellen. Hierbei arbeitet der erste Piezoaktor als Sensor und nimmt die auf den zweiten Piezoaktor wirkenden Kräfte auf und übermittelt diese an die Steuereinheit. Die Steuereinheit berechnet basierend auf den übermittelten Signalen eine exakte Position des Stellelements. Aufgrund des einfachen Steuerungsablaufs kann eine betriebssichere und kostengünstige Steuerung des Stellelements realisiert werden. Mit dem erfindungsgemäßen Verfahren kann eine Fluidmenge wesentlich genauer als über die herkömmliche Piezoaktor-Selektion in der Fertigung bestimmt werden, was in einer deutlichen Effizienzsteigerung von Verbrennungsmotoren resultiert, bei denen die Stelleinrichtung eingesetzt wird. Ferner ist eine kostengünstigere Fertigung der Stelleinrichtung mit einer geringen Anzahl von Fertigungsschritten und kürzeren Taktzeiten erreichbar. Alternativ kann das erfindungsgemäße Stellelement auch indirekt über ein Servoventil mit einer Bewegungsumkehr betätigt werden, wodurch ein Einsatz in einem weiten Bereich von Verbrennungsmotoren möglich ist.

Gemäß einer bevorzugten Ausgestaltung des Verfahrens wird basierend auf der berechneten Position des Stellelements eine Öffnungsdauer für eine Fluideinspritzung, insbesondere eine Kraftstoffeinspritzung oder Kraftstoffeinblasung, bestimmt. Dadurch kann selbst bei Einspritzvorgängen mit sehr hoher Frequenz bzw. sehr kurzen Taktzeiten eine präzise Fluiddosierung in allen Lastbereichen des Verbrennungsmotors erfolgen.

### Zeichnung

Nachfolgend werden Ausführungsbeispiele der Erfindung unter Bezugnahme auf die begleitende Zeichnung im Detail beschrieben. In der Zeichnung ist:
- Figur 1: eine geschnittene Teilansicht einer Stelleinrichtung gemäß einem ersten bevorzugten Ausführungsbeispiel der Erfindung,
- Figur 2: eine weitere geschnittene Teilansicht der Stelleinrichtung von Figur 1,

- Figur 3: eine Querschnittansicht eines ersten Piezoaktors des ersten Ausführungsbeispiels,
- Figur 4: eine Querschnittansicht eines zweiten Piezoaktors des ersten Ausführungsbeispiels, und
- Figur 5: eine geschnittene Teilansicht der Stelleinrichtung gemäß einem zweiten bevorzugten Ausführungsbeispiel der Erfindung.

### Ausführungsformen der Erfindung

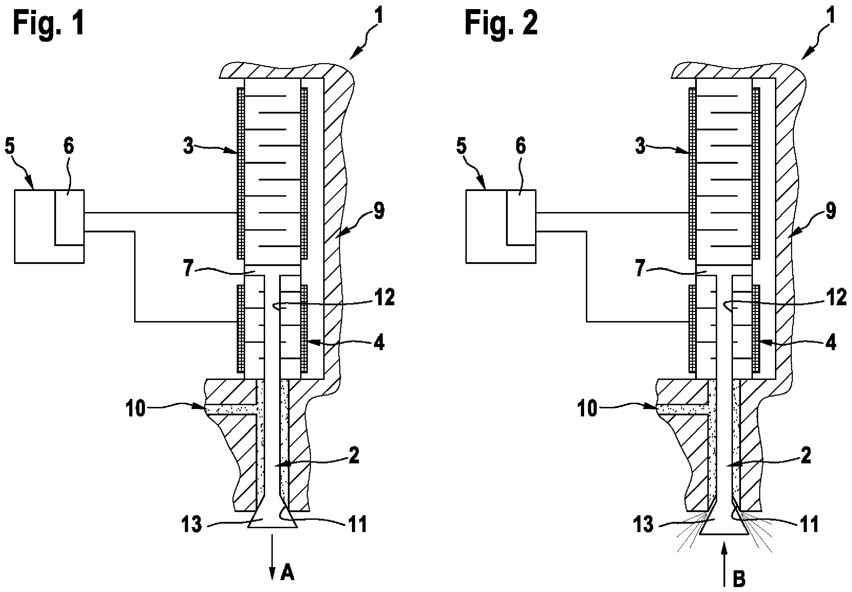

Nachfolgend wird unter Bezugnahme auf Figur 1 bis 4 eine Stelleinrichtung gemäß einem ersten bevorzugten Ausführungsbeispiel der Erfindung im Detail beschrieben.

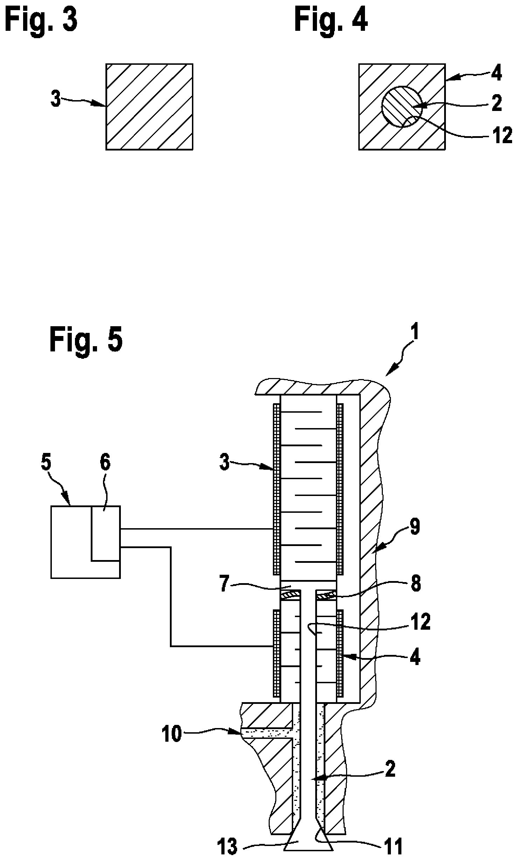

Figur 1 zeigt eine geschnittene Teilansicht einer Stelleinrichtung 1 gemäß dem ersten Ausführungsbeispiel der Erfindung. Die Stelleinrichtung 1 umfasst ein Stellelement 2, einen ersten Piezoaktor 3 und einen zweiten Piezoaktor 4, die vorzugsweise als keramische Vielschicht-Piezoaktoren ausgebildet und in einem Gehäuse 9 angeordnet sind, dem ein Fluid über eine Kraftstoffleitung 10 zugeführt wird. Ferner umfasst die Stelleinrichtung 1 eine außerhalb des Gehäuses 9 angeordnete Steuereinheit 5 mit einer darin vorgesehenen Recheneinheit 6, welche mit dem ersten Piezoaktor 3 und dem zweiten Piezoaktor 4 elektrisch verbunden ist. Die ersten und zweiten Piezoaktoren 3, 4 weisen, wie in Figur 3 und 4 dargestellt, jeweils einen quadratischen Querschnitt auf. Alternativ könnten die Piezoaktoren auch einen kreisförmigen Querschnitt aufweisen. Das als Nadel ausgebildete Stellelement 2 weist einen flachen Fußbereich 7 auf, der zwischen dem ersten und zweiten Piezoaktor 3, 4 angeordnet ist und an den ersten und zweiten Piezoaktoren 3, 4 direkt anliegt bzw. diese kontaktiert. Ein mit dem Fußbereich 7 verbundener Halsbereich 12 des Stellelements 2 ist, wie auch aus der Querschnittsansicht von Figur 4 ersichtlich, durch eine im zweiten Piezoaktor 4 ausgebildete Durchgangsöffnung 12 hindurchgeführt. Ein dem Fußbereich 7 gegenüberliegender Endbereich 13 des Stellelements 2 ist kegelförmig ausgebildet und verschließt einen im Gehäuse 9 gegenüberliegend angeordneten Ventilsitz 11. Figur 1 zeigt eine Ausgangsposition des Stellelements 2, welche die geschlossene Stellung ist.

Gemäß dem erfindungsgemäßen Verfahren wird zum Öffnen der Stelleinrichtung 1 der erste Piezoaktor 3 von der Steuereinheit 5 in einer als Pfeil dargestellten ersten Richtung A aktiviert bzw. angesteuert. Infolge der elektrischen Bestromung bzw. Belastung dehnt sich der erste Piezoaktor 3 aus und das mit dem Fußbereich 7 anliegende Stellelement 2 wird von einer Ausgangsposition in eine Stellposition bewegt. Der am Fußbereich 7 gegenüberliegend anliegende und am Gehäuse 9 abgestützte zweite Piezoaktor 4, der deaktiviert bzw. nicht angesteuert ist, wird hierbei durch die vom ersten Piezoaktor 3 erzeugte Kraft zusammengedrückt. Hierbei sei angemerkt, dass der Ausdruck "deaktiviert" hier im Sinne von "im Ruhezustand bzw. in Ruhestellung befindlich" zu verstehen ist, bei dem der hier elektrisch nicht belastete und zum Bewegen des Stellelements 2 nicht verwendete zweite Piezoaktor 4 lediglich zusammengedrückt wird und dabei als Sensor geschaltet ist, der die auf ihn wirkenden Kräfte vom Stellelement 2 aufnimmt. Die dabei erfassten Sensorsignale des zweiten Piezoaktors 4 werden an die Recheneinheit 6 in der Steuereinheit 5 übermittelt, die darauf basierend eine exakte Position des Stellelements 2 berechnet.

Wie in Figur 2 dargestellt, hebt der Endbereich 13 des Stellelements 2 aufgrund der Ausdehnung des ersten Piezoaktors 3 in der ersten Richtung A vom Ventilsitz 11 in die Stellposition ab, sodass das durch die Kraftstoffleitung 10 zugeführte Fluid zur Außenseite des Gehäuses 9 ausströmen kann.

Um das Stellelement 2 wieder auf den Ventilsitz 11 zurückzustellen bzw. die Stelleinrichtung 1 zu schließen, wird nun der zweite Piezoaktor 4 von der Steuereinheit 5 aktiviert und der erste Piezoaktor 3 deaktiviert. Hierbei dehnt sich der zweite Piezoaktor 4 aus und bewegt das Stellelement 2 von der in Figur 2 dargestellten Stellposition in einer durch einen Pfeil dargestellten zweiten Richtung B wieder in die Ausgangsposition zurück. Dadurch wird der erste, deaktivierte Piezoaktor 3 zusammengedrückt, der nun als Sensor geschaltet ist, um die vom zweiten Piezoaktor 4 auf ihn ausgeübte Kraft zu erfassen und als Sensorsignale an die Recheneinheit 6 in der Steuereinheit 5 zu übermitteln, die darauf basierend wieder eine exakte Position des Stellelements 2 berechnet.

Auf Grundlage der berechneten und bekannten Positionen des Stellelements 2 zu jedem Zeitpunkt des Einspritzvorgangs, dem sogenannten Nadelflugverhalten, kann die erforderliche Fluidmenge mit wesentlich höherer Präzision bestimmt werden als durch die üblicherweise beim Stand der Technik vor dem Einbau eingesetzten Piezoaktor-Vermessung und -Codierung. Hieraus resultieren große Kraftstoffeinsparpotentiale.

Nachfolgend wird mit Bezug auf Figur 5 eine Stelleinrichtung gemäß einem zweiten bevorzugten Ausführungsbeispiel der Erfindung detailliert beschrieben. Gleiche oder funktional gleiche Bauteile sind hier mit denselben Bezugszeichen wie im ersten Ausführungsbeispiel bezeichnet.

Im Gegensatz zum zuvor beschriebenen ersten Ausführungsbeispiel weist das zweite Ausführungsbeispiel ein Federelement 8 zur Unterstützung einer Rückstellung des Stellelements 2 auf. Das Federelement 8 ist zwischen dem zweiten Piezoaktor 4 und dem Fußbereich 7 des Stellelements 2 angeordnet. Alternativ dazu kann das Federelement 8 auch zwischen dem zweiten Piezoaktor 4 und dem Gehäuse 9 angeordnet sein. Hierdurch kann ein schnelleres Schließen des Stellelements 2 realisiert werden.

Obwohl in den Figuren nicht dargestellt, kann bei allen beschriebenen Ausführungsbeispielen zusätzlich ein hydraulischer Koppler zwischen dem ersten Piezoaktor 3 und dem Gehäuse 9 angeordnet bzw. hintergeschaltet werden, um einen Wärme bedingten Längenausgleich bereitzustellen

Die erfindungsgemäße Stelleinrichtung 1 weist den Vorteil auf, dass durch die Verwendung und getrennte Ansteuerung von zwei seriell verbauten Piezoaktoren 3, 4 einer der Piezoaktoren immer als Sensor arbeiten kann und eine exakte Position des Stellelements 2 bestimmen kann. Somit wird eine präzisere Bestimmung der Fluidmenge sowohl bei direkt- als auch indirekt betätigten Piezoaktoren erreicht. Ferner können dadurch der Kraftstoffverbrauch bzw. das Emissionsverhalten weiter reduziert und zukünftig vorgeschriebene Limitierungen eingehalten bzw. unterschritten werden.

## Patentansprüche

1. Stelleinrichtung, umfassend:
- ein Stellelement (2), welches in eine erste Richtung (A) und eine zweite Richtung (B) bewegbar angeordnet ist, wobei die ersten und zweiten Richtungen (A, B) einander entgegengesetzt sind,
- einen ersten Piezoaktor (3), und
- einen zweiten Piezoaktor (4),
- wobei der erste Piezoaktor (3) das Stellelement (2) in die erste Richtung (A) stellt, und
- wobei der zweite Piezoaktor (4) das Stellelement (2) in die zweite Richtung (B) stellt,
**dadurch gekennzeichnet,**
**dass** ferner eine Steuereinheit (5) umfasst ist, welche mit den ersten und zweiten Piezoaktoren (3, 4) verbunden ist und ausgelegt ist, den ersten und zweiten Piezoaktor (3, 4) abwechselnd zu aktivieren, und welche ferner ausgelegt ist, Signale des jeweils deaktivierten Piezoaktors zu erfassen.

2. Stelleinrichtung nach Anspruch 1, **dadurch gekennzeichnet, dass** der erste Piezoaktor (3) das Stellelement (2) von einer Ausgangsposition in eine Stellposition in die erste Richtung (A) stellt und der zweite Piezoaktor (4) das Stellelement von der Stellposition in die Ausgangsposition in die zweite Richtung (B) zurückstellt.

3. Stelleinrichtung nach Anspruch 1, **dadurch gekennzeichnet, dass** die Steuereinheit (5) eine Recheneinrichtung (6) umfasst, welche ausgelegt ist, eine exakte Position des Stellelementes (2) basierend auf den erfassten Signalen des jeweils deaktivierten Piezoaktors zu berechnen.

4. Stelleinrichtung nach einem der vorhergehenden Ansprüche, **dadurch gekennzeichnet, dass** der erste Piezoaktor (3) das Stellelement (2) direkt kontaktiert, und/oder dass der zweite Piezoaktor (4) das Stellelement (2) direkt kontaktiert.

5. Stelleinrichtung nach einem der vorhergehenden Ansprüche, **dadurch gekennzeichnet, dass** der zweite Piezoaktor (4) eine Durchgangsöffnung (12) zum Durchführen des Stellelements (2) aufweist.

6. Stelleinrichtung nach einem der vorhergehenden Ansprüche, **dadurch gekennzeichnet, dass** das Stellelement (2) eine Nadel ist, welche an einem Ende einen flachen Fußbereich (7) aufweist, der zwischen dem ersten und zweiten Piezoaktor (3, 4) angeordnet ist.

7. Stelleinrichtung nach einem der vorhergehenden Ansprüche, ferner umfassend ein Federelement (8) zur Unterstützung einer Rückstellung wenigstens eines der Piezoaktoren (3, 4).

8. Verfahren zum Stellen einer Stelleinrichtung mit einem Stellelement (2), einem ersten Piezoaktor (3) und einem zweiten Piezoaktor (4), umfassend die Schritte:
- Aktivieren des ersten Piezoaktors (3) in einer ersten Richtung (A), um das Stellelement (2) von einer Ausgangsposition in eine Stellposition zu stellen, wobei der zweite Piezoaktor (4) deaktiviert ist und als Sensor arbeitet und die auf den zweiten Piezoaktor (4) wirkenden Kräfte vom Stellelement (2) aufnimmt und an die Steuereinheit (5) übermittelt, und
- Deaktivieren des ersten Piezoaktors (3) und Aktivieren des zweiten Piezoaktors (4) in einer zweiten Richtung (B), um das Stellelement (2) von der Stellposition in die Ausgangsposition zurückzustellen, wobei der erste Piezoaktor (3) als Sensor arbeitet und die auf den zweiten Piezoaktor (4) wirkenden Kräfte aufnimmt und an die Steuereinheit (5) übermittelt,
- wobei die Steuereinheit (5) basierend auf den übermittelten Signalen eine exakte Position des Stellelements (2) berechnet.

9. Verfahren zum Stellen einer Stelleinrichtung nach Anspruch 8, **dadurch gekennzeichnet, dass** basierend auf der berechneten Position des Stellelements (2) eine Öffnungsdauer für eine Fluideinspritzung, insbesondere eine Kraftstoffeinspritzung oder Kraftstoffeinblasung, bestimmt wird.

## Claims

1. Actuating device, comprising:
- an actuating element (2) which is arranged such that it can be moved in a first direction (A) and a second direction (B), wherein the first and second directions (A, B) oppose one another,
- a first piezo actuator (3), and
- a second piezo actuator (4),
- wherein the first piezo actuator (3) actuates the actuating element (2) in the first direction (A), and
- wherein the second piezo actuator (4) actuates the actuating element (2) in the second direction (B),
**characterized**
**in that** a control unit (5) is further comprised, which control unit is connected to the first and second piezo actuators (3, 4) and is designed to activate the first and the second piezo actuator (3, 4) alternately, and which is further designed to detect signals from the respectively deactivated piezo actuator.

2. Actuating device according to Claim 1, **characterized in that** the first piezo actuator (3) actuates the actuating element (2) in the first direction (A) from a starting position to an actuating position and the second piezo actuator (4) returns the actuating element in the second direction (B) from the actuating position to the starting position.

3. Actuating device according to Claim 1, **characterized in that** the control unit (5) comprises a computer device (6) which is designed to calculate an exact position of the actuating element (2) based on the detected signals of the respectively deactivated piezo actuator.

4. Actuating device according to one of the preceding claims, **characterized in that** the first piezo actuator (3) makes direct contact with the actuating element (2), and/or **in that** the second piezo actuator (4) makes direct contact with the actuating element (2).

5. Actuating device according to one of the preceding claims, **characterized in that** the second piezo actuator (4) has a passage opening (12) for the actuating element (2) to pass through.

6. Actuating device according to one of the preceding claims, **characterized in that** the actuating element (2) is a needle which has a flat foot region (7) at one end, which flat foot region is arranged between the first and the second piezo actuator (3, 4).

7. Actuating device according to one of the preceding claims, further comprising a spring element (8) for assisting return of at least one of the piezo actuators (3, 4).

8. Method for actuating an actuating device comprising an actuating element (2), a first piezo actuator (3) and a second piezo actuator (4), comprising the steps of:
- activating the first piezo actuator (3) in a first direction (A) in order to actuate the actuating element (2) from a starting position to an actuating position, wherein the second piezo actuator (4) is deactivated and operates as a sensor and absorbs the forces acting on the second piezo actuator (4) from the actuating element (2) and transmits them to the control unit (5), and
- deactivating the first piezo actuator (3) and activating the second piezo actuator (4) in a second direction (B) in order to return the actuating element (2) from the actuating position to the starting position, wherein the first piezo actuator (3) operates as a sensor and absorbs the forces acting on the second piezo actuator (4) and transmits them to the control unit (5),
- wherein the control unit (5) calculates an exact position of the actuating element (2) based on the transmitted signals.

9. Method for actuating an actuating device according to Claim 8, **characterized in that** an opening period for a fluid injection operation, in particular a fuel injection operation, is determined based on the calculated position of the actuating element (2).

## Revendications

1. Dispositif d'actionnement, comprenant :
- un élément d'actionnement (2) qui est monté avec mobilité dans une première direction (A) et dans une deuxième direction (B), les première et deuxième directions (A, B) étant mutuellement opposées,
- un premier actionneur piézoélectrique (3) et
- un deuxième actionneur piézoélectrique (4),
- le premier actionneur piézoélectrique (3) actionnant l'élément d'actionnement (2) dans la première direction (A), et
- le deuxième actionneur piézoélectrique (4) actionnant l'élément d'actionnement (2) dans la deuxième direction (B),
**caractérisé en ce**
**qu'**il comporte en outre une unité de commande (5) qui est reliée aux premier et deuxième actionneurs piézoélectriques (3, 4) et qui est conçue pour activer les premier et deuxième actionneurs piézoélectriques (3, 4) en alternance, et qui est en outre conçue pour collecter des signaux de l'actionneur piézoélectrique respectivement désactivé.

2. Dispositif d'actionnement selon la revendication 1, **caractérisé en ce que** le premier actionneur piézoélectrique (3) actionne l'élément d'actionnement (2) d'une position initiale dans une position d'actionnement dans la première direction (A) et le deuxième actionneur piézoélectrique (4) ramène l'élément d'actionnement de la position d'actionnement dans la position initiale dans la deuxième direction (B).

3. Dispositif d'actionnement selon la revendication 1, **caractérisé en ce que** l'unité de commande (5) comporte un dispositif de calcul (6) qui est conçu pour calculer la position exacte de l'élément d'actionnement (2) en se basant sur les signaux collectés de l'actionneur piézoélectrique respectivement désactivé.

4. Dispositif d'actionnement selon l'une des revendications précédentes, **caractérisé en ce que** le premier actionneur piézoélectrique (3) entre directement en contact avec l'élément d'actionnement (2) et/ou **en ce que** le deuxième actionneur piézoélectrique (4) entre directement en contact avec l'élément d'actionnement (2).

5. Dispositif d'actionnement selon l'une des revendications précédentes, **caractérisé en ce que** le deuxième actionneur piézoélectrique (4) possède une ouverture de passage (12) servant à la traversée de l'élément d'actionnement (2).

6. Dispositif d'actionnement selon l'une des revendications précédentes, **caractérisé en ce que** l'élément d'actionnement (2) est une aiguille qui possède, à une extrémité, une zone de pied plate (7), laquelle est disposée entre le premier et le deuxième actionneur piézoélectrique (3, 4).

7. Dispositif d'actionnement selon l'une des revendications précédentes, comportant en outre un élément ressort (8) destiné à assister un retour d'au moins l'un des actionneurs piézoélectriques (3, 4).

8. Procédé pour actionner un dispositif d'actionnement comprenant un élément d'actionnement (2), un premier actionneur piézoélectrique (3) et un deuxième actionneur piézoélectrique (4), comprenant les étapes suivantes :
- activation du premier actionneur piézoélectrique (3) dans une première direction (A) afin d'actionner l'élément d'actionnement (2) d'une position initiale dans une position d'actionnement, le deuxième actionneur piézoélectrique (4) étant désactivé et faisant office de capteur et enregistrant les forces qui sont exercées par l'élément d'actionnement (2) sur le deuxième actionneur piézoélectrique (4) et les communiquant à l'unité de commande (5), et
- désactivation du premier actionneur piézoélectrique (3) et activation du deuxième actionneur piézoélectrique (4) dans une deuxième direction (B) afin de ramener l'élément d'actionnement (2) de la position d'actionnement dans la position initiale, le premier actionneur piézoélectrique (3) faisant office de capteur et enregistrant les forces qui sont exercées sur le deuxième actionneur piézoélectrique (4) et les communiquant à l'unité de commande (5),
- l'unité de commande (5) calculant une position exacte de l'élément d'actionnement (2) en se basant sur les signaux communiqués.

9. Procédé pour actionner un dispositif d'actionnement selon la revendication 8, **caractérisé en ce qu'**une durée d'ouverture pour une injection de fluide, notamment une injection de carburant ou une insufflation de carburant, est déterminée en se basant sur la position calculée de l'élément d'actionnement (2).
